# EUROPÄISCHE PATENTSCHRIFT

(11) **EP 1 092 340 B1**
(45) Veröffentlichungstag und Bekanntmachung des Hinweises auf die Patenterteilung: **13.08.2003**
(21) Anmeldenummer: 99929225.3
(22) Anmeldetag: 15.06.1999
(51) Int. Cl.: H05K 7/20

(54) **KÜHLSYSTEM FÜR EINE LEISTUNGSELEKTRONIK ZUM BETREIBEN WENIGSTENS EINES ELEKTRISCHEN AGGREGATES EINES KRAFTFAHRZEUGS**
COOLING SYSTEM FOR A POWER ELECTRONIC UNIT FOR OPERATING AT LEAST ONE ELECTRICAL GROUP OF A MOTOR VEHICLE
SYSTEME DE REFROIDISSEMENT POUR UNITE ELECTRONIQUE DE PUISSANCE, POUR ACTIONNER AU MOINS UN GROUPE ELECTRIQUE D'AUTOMOBILE

(30) Priorität: 16.06.1998 DE 19826733
(43) Veröffentlichungstag der Anmeldung: 18.04.2001
(73) Patentinhaber: Continental ISAD Electronic Systems GmbH & Co. oHG, 86899 Landsberg/Lech (DE)
(72) Erfinder: BLOME, Frank, D-49744 Geeste (DE)
(74) Vertreter: Lippich, Wolfgang, Dipl.-Phys, Dr.rer.nat.
(86) Internationale Anmeldenummer: EP9904141
(87) Internationale Veröffentlichungsnummer: WO99066774

(56) Entgegenhaltungen:
- WO-A-98/07306
- DE-A- 2 046 750
- DE-A- 3 236 612
- US-A- 3 417 814

## Beschreibung

Die Erfindung betrifft ein Kühlsystem für eine Leistungselektronik zum Betreiben wenigstens eines elektrischen Aggregates eines Kraftfahrzeugs, insbesondere eines Starter/Generators mit einem druckdichten Behälter zur Aufnahme einer elektronischen Anordnung und eines diese bedeckendes Bades aus einer elektrisch isolierenden ersten Kühlflüssigkeit, die bei einem Betriebsdruck eine Siedetemperatur aufweist, welche die noch zulässige Betriebstemperatur der elektronischen Anordnung nicht übersteigt, und einem Wärmeaustauscher, der oberhalb des Spiegels der ersten Kühlflüssigkeit angeordnet ist oder mit diesem durch eine Leitungsanordnung verbunden ist, wobei in der elektronischen Anordnung verdampfte erste Kühlflüssigkeit als Dampf zum Wärmeaustauscher gelangt, dort kondensiert und wieder zum Bad zurückgelangt, wodurch ein erster Kühlflüssigkeitsumlauf gebildet wird.

Herkömmliche Kraftfahrzeuge weisen eine erhebliche Anzahl von Leistungsverbrauchern auf, wie etwa den Ventiltrieb des Verbrennungsmotors, einen Klimakompressor, einen Bremskraftverstärker, eine Servolenkung und dergleichen mehr. Von diesen wird nur eine gewisse Anzahl solcher Einrichtungen, die nur eine verhältnismäßig geringe Leistungsaufnahme besitzen, elektrisch betrieben, etwa die Antriebe für Fensterscheiben, Verriegelung, Schiebedach und Klappverdeck. Lediglich der elektrische Startermotor weist eine Leistungaufnahme von einigen kW auf, ist aber nur für den vereinzelten, kurzzeitigen Betrieb eingerichtet, nicht zuletzt deshalb, weil die Batteriekapazität des Fahrzeuges einen Betrieb mit nur sehr kurzer Dauer gestattet.

Im übrigen werden Leistungsverbraucher an den Hauptantrieb angekoppelt, von dem sie über die Welle (Ventiltrieb, Klimakompressor) oder über den Ansaugunterdruck (Bremskraftverstärker) betrieben werden. Insgesamt sind also die wesentlichen Leistungsverbraucher mechanisch oder pneumatisch mit dem Hauptantrieb gekoppelt, wobei diese Koppelung oft umständlich erfolgt und die Möglichkeiten der Anordnung der Leistungsverbraucher stark einengt. Variable Betriebsweisen - etwa bei dem Ventiltrieb - sind durch diese Art der Kopplung erschwert, ein optimaler Wirkungsgrad (etwa bei dem Klimakompressor) ist angesichts der zumeist festen Drehzahlkopplung schwerlich erzielbar.

Ein weiterer Nachteil der beschriebenen, üblichen Anordungsweise liegt in der Tatsache, daß die Leistungsverbraucher nicht betrieben werden können, wenn der Hauptantrieb nicht läuft. Dies schafft Probleme bei der Realisierung einer - unter Umweltschutzgesichtspunkten besonders wünschenswerten - Start-Stop-Automatik und auch beim Abschleppen von Fahrzeugen bei stehendem Motor des geschleppten Fahrzeuges.

Die oben umrissenen Probleme würden ausgeräumt, wenn die Elektroanlage des Fahrzeuges wesentlich leistungsfähiger ausgelegt würde, denn dann könnten alle Leistungsverbraucher elektrisch betrieben werden. Sie könnten dann auch an dem für sie günstigsten Ort im Fahrzeug montiert werden, da ja nicht mehr, wie bisher, eine mechanische oder pneumatische Verbindung mit dem Hauptantrieb vorliegen müßte, und könnten variable bei hohem Wirkungsgrad betrieben werden. Die bisherige Lichtmaschine würde durch einen größeren Generator mit einer Leistung von mehreren Kilowatt ersetzt, die bei entsprechendem Aufbau auch als Startermotor verwendbar wäre, so daß dieser entfallen könnte.

Neben der ganz erheblichen baulichen Vereinfachung ergäbe sich auch die Möglichkeit, daß Leistungsverbraucher betrieben werden können, auch wenn der Hauptantrieb nicht in Betrieb ist, solange die vorhandene Batteriekapazität ausreicht. Auch eine Start-Stop-Automatik wäre einfacher realisierbar.

Mit einer entsprechend dimensionierten Elektroanlage könnten auch neuartige Einrichtungen betrieben werden, die bisher praktisch kaum realisierbar sind, etwa ein elektromagnetischer Ventiltrieb, eine fahrzeugeigene elektrische Kühlwasservorwärmung für den verschleißarmen Kaltstart im Winter oder eine elektrische Katalysatorvorheizung zur Vermeidung von Schadstoffemissionen in der Warmlaufphase. Der Gewichtsaufwand für eine größere, mitzuführende Batterie würde zumindest teilweise durch die Gewichtsersparnis wettgemacht, die der Wegfall der bisherigen mechanischen Antriebsübertragungen erbringen würde.

Auch die Verluste an den einzelnen Leistungsverbrauchern könnten optimiert werden, schon deshalb, weil deren Betriebsverhalten besser an den Bedarf angepaßt werden könnte, beispielsweise könnte ein Klimakompressor konstant bei der wirkungsgradmäßig optimalen Drehzahl angetrieben werden.

Für eine entsprechend dimensionierte Elektroanlage ist allerdings ein entsprechend leistungsstarker Generator mit zugehöriger Leistungselektronik erforderlich, wie er z.B. aus der WO97/08456 bekannt ist. Der dort beschriebene Generator ist eine elektrische Wechselstrommaschine, die auch als Starter für den Verbrennungsmotor fungiert. Die Leistungselektronik ist im wesentlichen ein Umrichter mit Halbleiter-Leistungsschaltern, welcher beim Generatorbetrieb bremsende magnetische Drehfelder erzeugt und die so von der Maschine gelieferten Wechselströme mit Hilfe der Leistungsschalter in Gleichstrom umsetzt. Beim Motorbetrieb erzeugt er entsprechend antreibende magnetische Drehfelder, die hierfür benötigten Wechselströme werden mit Hilfe der Leistungsschalter aus Gleichstrom erzeugt.

Neben der elektrischen Maschine hat die Leistungselektronik einen beträchtlichen Kühlbedarf. Beträgt etwa die Dauerleistung 20 kW bei Halbleiterverlusten von 2%, so ist eine Kühlleistung von 400 W erforderlich. Um trotz dieser hohen Kühlleistung die Leistungselektronik kompakt aufbauen zu können, kommt eine Siedebadkühlung zur Anwendung. Als Kühlmittel wird z.B. ein Chlorfluorkohlenstoff verwendet, der elektrisch nichtleitend ist und die eng gepackten, in einem druckdichten Behälter angeordneten Bauteile der Leistungselektronik umspült. Wenn die örtliche Temperatur den Siedepunkt des Kühlmittels erreicht und diesem weiter Wärme zugeführt wird, dann verdampft es unter Aufnahme latenter Wärme, und die dabei gebildeten Dampfblasen steigen in der Kühlflüssigkeit durch die Auftriebskräfte sofort nach oben und lassen unverdampfte Kühlflüssigkeit zu der zu kühlenden Stelle. In einem Luftkühler gibt der Dampf die aufgenommene latente Wärme ab und kondensiert dabei. Die Flüssigkeit gelangt wieder in den Behälter, wo dieser Kühlkreislauf von neuem beginnt.

Damit der Dampf allein durch die Auftriebskräfte in den Kühler und das Kondensat entsprechend in den Behälter gelangen können, muß der Kühler über den Behälter mit der Leistungselektronik angeordnet sein. Diese zwingend einzuhaltende Randbedingung kann das Auffinden einer geeigneten Einbauposition sehr erschweren. Gerade in Kraftfahrzeugen spielt aber die Frage der Unterbringung von Aggregaten oft eine entscheidende Rolle. Derartige Schwierigkeiten dürften einer der Gründe sein, warum die moderne Leistungselektronik - obschon seit über zwei Jahrzehnten an sich bekannt - bisher im Kraftfahrzeug keine breitere Anwendung gefunden hat.

Eine entsprechende Siedebadkühlung ist allgemein z.B. aus der DE 42 30 510 C1 bekannt.

Die DE 32 36 612 C2 offenbart eine Anwendung im Eisenbahnbereich, bei der für lange Tunnelfahrten mit entsprechend hohen Außentemperaturen eine weitere Rückkühlmöglichkeit in einem Wärmespeicher vorgesehen ist. Hierzu wird der Kondensator über einen zweiten Flüssigkeitskreislauf gekühlt, der wiederum seine Wärme in einen Wasserspeicher abgibt.

Ausgehend von diesem Stand der Technik liegt der Erfindung die Aufgabe zugrunde, ein für den Einbau in ein Kraftfahrzeug vorteilhafter eingerichtetes Kühlsystem für eine Leistungselektronik anzugeben.

Insbesondere soll dieser Einbau raumsparend und an einer weitgehend frei wählbaren Stelle erfolgen, damit der nicht für Personen oder Fracht im Fahrzeug zur Verfügung stehende Raum klein ausgebildet werden kann.

Zur Lösung dieser Aufgabe wird ein Kühlsystem der eingangs genannten Art bereitgestellt, das dadurch gekennzeichnet ist, daß ein zweiter Kühlflüssigkeitsumlauf mit einer zweiten Kühlflüssigkeit, welche einen Kühler aufweist und den Wärmeaustauscher kühlt, vorgesehen ist, der zweite Kühlflüssigkeitsumlauf zumindest eine Kühlflüssigkeits-Tiefstelle aufweist, die unter dem Wärmeaustauscher liegt, und der zweite Kühlflüssigkeitsumlauf eine Pumpe zum Erzwingen eines Umlaufstromes der zweiten Kühlflüssigkeit aufweist.

Hierdurch muß der Kühlflüssigkeitsumlauf nicht, wie es bisher notwendig war, stets ansteigend bis zu einem Kühler geführt werden, sondern er weist eine tiefste Stelle auf, die unter dem Flüssigkeitsspiegel der Kühlflüssigkeit für die Leistungselektronik liegt.

Die Ausrüstung mit einem zweiten Kühlflüssigkeitsumlauf und das Vorhandensein einer Tiefstelle implizieren eine wesentlich größere Freiheit bei der Anordnung des Kühlers, denn dieser konnte bei den herkömmlichen Lösungen nur in demjenigen Bereich des Kraftfahrzeugs angeordnet werden, der über eine ausschließlich ansteigende Leitung von der Leistungselektronik erreichbar war. Das Erfordernis der ausschließlich ansteigenden Leitung fällt durch die Erfindung weg, die Leitung kann nun beispielsweise, auch wenn der Kühler niveaumäßig über der Leistungselektronik angeordnet ist, zunächst abfallen und etwa erst nach Unterquerung eines Hindernisses zum Kühler ansteigen. Der Kühler kann aber auch unterhalb des Niveaus der Leistungselektronik liegen, also selbst die Tiefstelle darstellen, ggf. neben weiteren Tiefstellen in der Zuleitung (s. Anspruch 2).

Dabei ist der einen Kondensator bildende Wärmeaustauscher zum Kühlen des Dampfes der ersten Kühlflüssigkeit vorzugsweise in oder auf dem druckdichten Behälter angeordnet, z.B. innen unmittelbar über dem Flüssigkeitsspiegel (s. Anspruch 3). Alternativ ist er gegenüber dem Behälter abgesetzt und mit diesem über eine Leitungsanordnung verbunden.

Es sind also zwei Grundbauweisen möglich: bei der einen befindet sich der Wärmeaustauscher innerhalb des dichten Behälters oder auf diesem, an dessen Außenseite dann neben elektrischen Anschlüssen vorteilhaft nur zwei Rohr- oder Schlauchanschlüsse vorliegen, die an den zweiten Kühlflüssigkeitsumlauf angeschlossen werden müssen. Diese Ausführung hat den Vorteil, daß beim Einbau oder Austausch neben der Herstellung elektrischer Anschlüsse lediglich die (i.a. auf Umgebungsdruck betriebenen) Rohrleitungen des zweiten Kühlflüssigkeitsumlaufes angeschlossen werden müssen; der abgekapselte, in der Regel zwecks Siedepunkteinstellung unter einem anderen Innendruck als dem Umgebungsdruck gehaltene Behälter, der die elektronische Anordnung enthält, bedarf seinerseits außer Einbau und Anschluß keinerlei weiteren Bearbeitung.

In der anderen Grundbauweise ist der Wärmeaustauscher gegenüber dem dichten Behälter abgesetzt und ist mit diesem über je eine Leitung für Dampf und kondensierte Kühlflüssigkeit verbunden.

In dem Leitungssystem des zweiten Kühlflüssigkeitsumlaufs ist eine Pumpe zum Entfachen und Aufrechterhalten einer Zwangs-Umlaufströmung vorgesehen, so daß trotz absteigender Leitungsabschnitte gewährleistet ist, daß im Wärmeaustauscher erwärmte Kühlflüssigkeit zum Kühler und in diesem abgekühlte Kühlflüssigkeit wieder zurück zum Wärmeaustauscher gelangt. Die zweite Kühlflüssigkeit ist z.B. Wasser.

Auf diese Weise kann also die Leistungselektronik dort im Kraftfahrzeug angebracht werden, wo es am zweckmäßigsten ist, und der Kühler sowie gegebenenfalls auch der Wärmeaustauscher können ihrerseits an einer Stelle angebracht werden, die besonders günstig ist und etwa für den Kühler einen besonders günstigen Kühlluftstrom erbringt, ohne daß man sperrige Kühlluftleitungen verlegen muß.

Die Erfindung erlaubt es, Leitungen, die den Behälter mit dem Wärmeaustauscher oder diesen mit einem Kühler verbinden, frei und ohne jeden Zwang zu verlegen, z.B. an den Wänden oder an der Unterkante des Motorraumes, so daß etwa bei Ein- und Ausbau des Motors und sonstiger Aggregate nicht Leitungen im Wege stehen, die dann entsprechend ein- und ausgebaut werden müssen und das Ablassen und Einfüllen von Kühlwasser oder Kühlflüssigkeit erfordern.

Folglich macht die Erfindung den Einsatz von Leistungselektronik im Kraftfahrzeug praktikabler. Bei einem solcherart ausgestatteten Kraftfahrzeug weist der den Hauptantrieb bildende Verbrennungsmotor vorzugsweise statt vieler mechanischer und pneumatischer Ableitungen nur noch eine elekrische Maschine auf, die sowohl die Funktion des Generators als auch des Starters hat, in ständigem Antriebseingriff mit dem Hauptantriebsmotor steht, sogar und in dessen Aufbau - etwa zwischen Motor und Getriebe - integriert sein kann.

Der zweite Kühlflüssigkeitsumlauf weist einen als "Kühler" bezeichneten Wärmeaustauscher auf. Vorzugsweise ist dieser Kühler luftdurchströmt (Anspruch 4). Es ist nun mit der Erfindung nicht etwa erforderlich, die Kühlluft zum Kühler zu fördern, vielmehr kann der Kühler dort montiert werden, wo ein Kühlluftstrom vorliegt, z.B. an einer Stelle, an der er dem Fahrtwind ausgesetzt ist, oder hinter dem Kühllüfter des Antriebsmotors. Es ist aber auch möglich, einen eigenen elektrischen Lüfter für den Kühler vorzusehen. Als raumsparende Anordnungsstelle ist beispielsweise der Raum unter dem Kühler für den Antriebsmotor vorteilhaft, so daß der Kühler dann, wenn er dort angebracht ist, auch an der oder zumindest einer Kühlwasser-Tiefstelle angebracht ist.

Die Pumpe des zweiten Kühlflüssigkeitsumlaufs kann wahlweise im kälteren oder im wärmeren Zweig angeordnet sein.

Der Gegenstand der vorliegenden Erfindung wird nun anhand von Ausführungsbeispielen und der angefügten Zeichnung näher erläutert. In dieser zeigen:
- Fig. 1: eine schematische Darstellung eines ersten Ausführungsbeispiels mit einer Tiefstelle in den Leitungen des zweiten Kühlflüssigkeitsumlaufs, und
- Fig. 2: eine schematische Darstellung eines zweiten Ausführungsbeispiels, bei welcher der Kühler des zweiten Kühlflüssigkeitsumlaufs tiefer als der Flüssigkeitsspiegel der ersten Kühlflüssigkeit liegt.

Die in Fig. 1 oder 2 gezeigte Einrichtung ist in ein Kraftfahrzeug eingebaut, das der einfacheren Darstellung halber weggelassen ist. In beiden Figuren bedeuten gleiche Bezugszeichen gleiche oder gleichartige Elemente oder Baugruppen.

Ausdrücke wie "hoch" und "tief" beziehen sich auf die Richtung der Auftriebskraft bei normaler Einbaulage des Kühlsystems.

In einem druckdichten Behälter 2 ist in dessen unterer Bereich eine nur durch ein Kästchen angedeutete Leistungselektronik 1 angeordnet. Hierbei handelt es sich um einen Umrichter mit Halbleiter-Leistungsschaltern zur Ansteuerung einer elektrischen Drehstrommaschine, welcher als Generator, der zur Versorgung von elektrischen Hochleistungsverbrauchern geeignet ist, sowie als Starter für den Verbrennungsmotor des Kraftfahrzeugs dient. Der Umrichter erzeugt bei Generatorbetrieb bremsende magnetische Drehfelder und setzt so die von der Maschine gelieferten Wechselströme mit Hilfe der Leistungsschalter in Gleichstrom um. Bei Motorbetrieb erzeugt er entsprechend antreibende magnetische Drehfelder, die hierfür genötigten Wechselströme werden mit Hilfe der Leistungsschalter aus Gleichstrom erzeugt.

Die Leistungselektronik ist vollständig in einem Bad 3 aus einer elektrisch isolierenden Flüssigkeit untergetaucht, deren Siedetemperatur niedriger ist als die zulässige Betriebstemperatur der Bauteile der Elektronik 1. Es handelt sich beispielsweise um einen Fluorchlorkohlenwasserstoff, der bei einem Betriebsdruck von ca. 2 bar eine Siedetemperatur von 60°C aufweist. Beim Betrieb der Leistungselektronik 1 steigt die Temperatur der Leistungshalbleiter aufgrund der Halbleiterverluste auf die Siedetemperatur und bringt an diesen Stellen die Kühlflüssigkeit des Bades 3 zum Sieden, wodurch eine erhebliche Wärmemenge abgegeben wird, um die Kühlflüssigkeit zu verdampfen. Der so gebildete Dampf steigt nach oben.

In der gezeigten Ausführungsform ist ein Wärmeaustauscher 5 in den Behälter 2 an dessen Oberseite hermetisch dicht integriert. Dieser Wärmeaustauscher 5 ist an seiner Unterseite zum Innenraum des Behälters 2 hin offen; der Dampf gelangt also direkt zu dessen Wärmesenken, kondensierte Kühlflüssigkeit tropft von dort wieder in das Bad zurück. Bei anderen (nicht gezeigten) Ausführungsformen ist der Wärmeaustauscher ein gesondertes Bauteil, welches oberhalb des Behälters angeordnet ist und über ausschließlich ansteigende Rohrleitungen mit dem Behälter verbunden ist. Bei weiteren (ebenfalls nicht gezeigten) Ausführungsformen ist der Wärmeaustauscher in den Behälter integriert, jedoch über einen mit einem Dampfeinlaß versehenen Zwischenboden abgetrennt; die kondensierte Kühlflüssigkeit kann dann gesammelt und durch einen Auslaß in das Bad zurückgeführt werden, der z.B. als knapp über dem Boden des Behälters endendes Tauchrohr ausgebildet ist.

Der Wärmeaustauscher 5 wird von einer Leitung einer zweiten Kühlflüssigkeit in Wärmekontakt durchsetzt, das an einen zweiten Kühlflüssigkeitsumlauf 6 angeschlossen ist. Im Betrieb wird die erste Kühlflüssigkeit im Behälter 2 verdampft, steigt allein aufgrund der Auftriebskräfte (also ohne Wirkung einer Pumpe o.ä.) zum Wärmeaustauscher 5 auf, wird in diesem kondensiert und strömt in das Bad 3 zurück.

Der zweite Kühlflüssigkeitsumlauf 6 weist eine Leitung auf, die vom Wärmeaustauscher 5 weg zu einem Kühler 8 führt, und eine weitere Leitung, die vom Kühler 8 zum Wärmeaustauscher 5 führt und in der eine Umwälzpumpe 7 angeordnet ist, die den Kreislauf der zweiten Kühlflüssigkeit im zweiten Kühlflüssigkeitsumlauf 6 erzwingt. Der Kühler 8 wird vom Fahrwind oder mittels eines (nicht gezeigten) Lüfters mit Luft gekühlt. So wird die durch Verdampfen der ersten Kühlflüssigkeit aufgenommene Wärme letztlich über den Kühler 8 an die Umgebungsluft abgegeben. Bei der zweiten Kühlflüssigkeit kann es sich z.B. um Wasser handeln. Hier braucht kein Phasenübergang bei dem Wärmeübergang und -transport mitzuwirken, es genügt i.a. die Wärmemenge der umlaufenden zweiten Kühlflüssigkeit in der flüssigen Phase.

Die Rohrleitungen des zweiten Kühlflüssigkeitsumlaufs 6 verlaufen an zumindest einer Stelle tiefer als der Spiegel der ersten Kühlflüssigkeit. Dies erlaubt die Unterquerung eines den direkten Weg versperrenden Teils im Kraftfahrzeug. Bei dem Ausführungsbeispiel der Fig. 2 liegt der Kühler 8 tiefer als der Spiegel der ersten Kühlflüssigkeit, er bildet also selbst die "Tiefstelle" des zweiten Kühlflüssigkeitsumlaufs. Dies erlaubt, den Kühler auf einem geeigneten tiefen Niveau im Kraftfahrzeug anzuordnen.

In vielen Fällen kann so auch in der räumlichen Beengung eines Kraftfahrzeuges das Kühlsystem ohne weiteres so montiert werden, daß sowohl der Kühler 8 als auch die Elektronik 1 jeweils an ihrer individuell optimalen Lage angeordnet werden können.

## Patentansprüche

1. Kühlsystem für eine Leistungselektronik zum Betreiben wenigstens eines elektrischen Aggregates eines Kraftfahrzeugs, insbesondere eines Starters/Generators, mit
- einem druckdichten Behälter (2) zur Aufnahme einer elektronischen Anordnung (1) und eines diese bedekkendes Bades (3) aus einer elektrisch isolierenden ersten Kühlflüssigkeit, die bei einem Betriebsdruck eine Siedetemperatur aufweist, welche die noch zulässige Betriebstemperatur der elektronischen Anordnung (1) nicht übersteigt, und
- einem Wärmeaustauscher (5), der oberhalb des Spiegels der ersten Kühlflüssigkeit angeordnet ist oder mit diesem durch eine Leitungsanordnung (9) verbunden ist, wobei in der elektronischen Anordnung (1) verdampfte erste Kühlflüssigkeit als Dampf zum Wärmeaustauscher (5) gelangt, dort kondensiert und wieder zum Bad (3) zurückgelangt, wodurch ein erster Kühlflüssigkeits-umlauf gebildet wird,
**dadurch gekennzeichnet, daß**
- ein zweiter Kühlflüssigkeitsumlauf mit einer zweiten Kühlflüssigkeit, welche einen Kühler (8) aufweist und den Wärmeaustauscher (5) kühlt, vorgesehen ist,
- der zweite Kühlflüssigkeitsumlauf (6) zumindest eine Kühlflüssigkeits-Tiefstelle aufweist, die unter dem Wärmeaustauscher (5) liegt, und
- der zweite Kühlflüssigkeitsumlauf (6) eine Pumpe (7) zum Erzwingen eines Umlaufstromes der zweiten Kühlflüssigkeit aufweist.

2. Kühlsystem nach Anspruch 1, **dadurch gekennzeichnet, daß** die oder eine Kühlflüssigkeits-Tiefstelle durch den Kühler (8) gebildet ist.

3. Kühlsystem nach Anspruch 1, **dadurch gekennzeichnet, daß** der Wärmeaustauscher (5) in oder auf dem Behälter (2) angeordnet ist.

4. Kühlsystem nach einem der Ansprüche 1 bis 3, **dadurch gekennzeichnet, daß** der Kühler luftdurchströmt ist.

## Claims

1. A cooling system for a power electronics module for operating at least one electrical unit in a motor vehicle, in particular a starter motor/generator, having
- a pressure-sealed compartment (2) for housing an electronic assembly (1) and a bath (3) of an electrically insulating first coolant covering it, which at an operating pressure has a boiling temperature which does not exceed the still permissible operating temperature of the electronic assembly (1), and
- a heat exchanger (5), which is disposed above the meniscus of the first coolant or is connected to this by means of pipe arrangement (9), where first coolant vaporised in the electronic assembly (1) reaches the heat exchanger (5) as steam, condenses there and flows back to the bath (3) again, thus forming a circulation of the first coolant,
**characterised in that**
- a second coolant circulation with a second coolant is provided, which comprises a cooler (8) and cools the heat exchanger (5),
- the second coolant circulation (6) comprises at least one low point for the coolant which lies beneath the heat exchanger (5), and
- the second coolant circulation (6) comprises a pump (7) for forcing a circulating flow of the second coolant.

2. A cooling system according to Claim 1,
**characterised in that** the or a low point of the coolant is formed by the cooler (8).

3. A cooling system according to Claim 1,
**characterised in that** the heat exchanger (5) is disposed in or on the compartment (2).

4. A cooling system according to one of Claims 1 to 3,
**characterised in that** air flows through the cooler.

## Revendications

1. Système de refioidissemont pour une unité électronique de puissance, pour actionner au moins un groupe électrique d'un véhicule automobile, notamment un démarreur / génératrice, comprenant :
un réservoir (2) étanche en pression, destiné au logement d'un montage électronique (1) et d'un bain (3) recouvrant ce dernier, constitué d'un premier liquide de refroidissement à isolation électrique, lequel liquide, en présence d'une pression d'exploitation, a une température d'ébullition qui n'est pas supédeure à la température d'exploitation encore admissible du montage électronique (1), et :
un échangeur de chaleur (5) disposé au-dessus de la surface du premier liquide de refroidissement ou relié à cette surface par l'intermédiaire d'un montage de conduites (9), le premier liquide de refroidissement qui s'évapore dans le montage électronique (1) arrivant sous forme de vapeur dans l'échangeur de chaleur (5), y étant condensé et étant renvoyé dans le bain (3), un premier circuit de liquide de refroidissement étant ainsi formé,
**caractérisé en ce que**
un deuxième circuit de liquide de refroidissement avec un deuxième liquide de refroidissement est prévu, lequel liquide présente un refroidisseur (8) et refroidit l'échangcur de chaleur (5),
le deuxième circuit de liquide de refroidissement (6) présente au moins un point bas de liquide de refroidissement se trouvant en dessous de l'échangeur de chaleur (5), et que
le deuxième circuit de liquide de refroidissement (6) présente une pompe (7) imposant un courant de circulation au deuxième liquide de refroidissement.

2. Système de refroidissement selon la revendication 1, **caractérisé en ce que** le ou un point bas du liquide de refroidissement est constitué par le refroidisseur (8).

3. Système de refroidissement selon la revendication 1, **caractérisé en ce que** l'échangeur de chaleur (5) est diaposé dans ou sur le réservoir (2).

4. Système de refroidissement selon l'une des revendications 1 à 3, **caractérisé en ce que** de l'air passe à travers le refroidisseur.
